# EUROPEAN PATENT APPLICATION

(11) **EP 4 080 583 A1**
(43) Date of publication of application: **26.10.2022**
(21) Application number: 22161830.9
(22) Date of filing: 14.03.2022
(51) Int. Cl.: H01L 29/78, H01L 21/336

(54) **SEMICONDUCTOR DEVICE AND METHOD OF MAKING A SEMICONDUCTOR DEVICE**

(30) Priority: 22.04.2021 US 202117237389
(71) Applicant: NXP USA, Inc., Austin TX 78735 (US)
(72) Inventor: MEHROTRA, Saumitra Raj, 5656AG Eindhoven (NL); XIA, Kejun, 5656AG Eindhoven (NL)
(74) Representative: Krott, Michel

(57) **Abstract**

A laterally-diffused metal-oxide semiconductor, "LDMOS", device and a method of making the same. The device includes a gate located on a major surface of a semiconductor die, a source region located in the die on a first side of the gate, a drain drift region located in the die on a second side of the gate opposite the first side, a first spacer located adjacent to a first sidewall of the gate on the first side of the gate, and a second spacer located adjacent to a second sidewall of the gate on the second side of the gate. The second spacer is located between the gate and the drain drift region. The second spacer comprises a proximal spacer portion and a distal spacer portion. The proximal spacer portion is located between the gate and the distal spacer portion. The proximal spacer portion and the distal spacer portion define a recess.

## Description

### BACKGROUND

The present specification relates to a laterally-diffused metal-oxide semiconductor, "LDMOS", device and to a method of making a laterally-diffused metal-oxide semiconductor, "LDMOS", device.

In recent years, automotive, industrial, and consumer applications have placed increasing demands on Smart Power technologies, which integrate digital, analog, and high-voltage power transistors in one chip, to seek to lower the manufacturing costs. This particularly applies to low voltage range (5-10V) technologies, which are attractive for consumer electronics applications.

Self-aligned laterally-diffused metal-oxide semiconductor (hereinafter, LDMOS) devices are popular devices in this voltage range. The breakdown voltage of a self-aligned LDMOS device may generally be limited by the gate oxide thickness of the device.

### SUMMARY

Aspects of the present disclosure are set out in the accompanying independent and dependent claims. Combinations of features from the dependent claims may be combined with features of the independent claims as appropriate and not merely as explicitly set out in the claims.

According to an aspect of the present disclosure, there is provided a method of making a laterally-diffused metal-oxide semiconductor, "LDMOS", device, the method comprising:
providing a semiconductor die having a major surface;
forming a gate on the major surface of the semiconductor die;
forming a first spacer located adjacent to a first sidewall of the gate on a first side of the gate;
forming a second spacer located adjacent to a second sidewall of the gate on a second side of the gate opposite said first side of the gate;
forming a source region located in the semiconductor die on said first side of the gate; and
forming a drain drift region located in the semiconductor die on said second side of the gate,
wherein the second spacer is located between the gate and the drain drift region when viewed from above said major surface of the semiconductor die, wherein the second spacer comprises a proximal spacer portion and a distal spacer portion, wherein the proximal spacer portion is located between the gate and the distal spacer portion, and wherein the proximal spacer portion and the distal spacer portion define a recess located in a center region of the second spacer.

The method may include:
forming the gate includes forming a sacrificial gate portion laterally separated from the gate on the second side of the gate; and
forming the second spacer comprises forming the proximal spacer portion adjacent to the second sidewall of the gate and forming the distal spacer portion adjacent to a sidewall of the sacrificial gate portion facing the second sidewall of the gate.

The method may include removing the sacrificial gate portion after forming the second spacer.

The method may include:
depositing a mask on the gate, the first spacer and at least part of the second spacer; and
removing the sacrificial gate portion by etching.

The method may include forming the drain drift region after removal of the sacrificial gate portion.

The sacrificial gate portion may be laterally separated from the gate by a distance that is greater than a lateral width of the first spacer and smaller than twice the lateral width of the first spacer. The proximal spacer portion may adjoin the distal spacer portion at the center region of the second spacer.

The sacrificial gate portion may be laterally separated from the gate by a distance that is greater than twice a lateral width of the first spacer. The proximal spacer portion may be laterally separated from the distal spacer portion.

The method may include:
depositing an oxide layer over the gate, the sacrificial gate portion, the first spacer and the second spacer; and
etching the oxide layer back, to form:
   a first oxide spacer part that overlies at least part of the first spacer; and
   a second oxide spacer part that overlies at least the center region of the second spacer.

The second oxide spacer part may at least partially fill a space located between the proximal spacer portion and the distal spacer portion.

The method may include:
masking the second spacer; and
removing the first oxide spacer part from the first spacer.

The method may include depositing a layer of dielectric to completely cover the gate, the first spacer and the second spacer.

According to another aspect of the present disclosure, there is provided a laterally-diffused metal-oxide semiconductor, "LDMOS", device comprising:
a gate located on a major surface of a semiconductor die;
a source region located in the semiconductor die on a first side of the gate
a drain drift region located in the semiconductor die on a second side of the gate opposite said first side of the gate;
a first spacer located adjacent to a first sidewall of the gate on said first side of the gate; and
a second spacer located adjacent to a second sidewall of the gate on said second side of the gate,
wherein the second spacer is located between the gate and the drain drift region when viewed from above said major surface of the semiconductor die, wherein the second spacer comprises a proximal spacer portion and a distal spacer portion, wherein the proximal spacer portion is located between the gate and the distal spacer portion, and wherein the proximal spacer portion and the distal spacer portion define a recess located in a center region of the second spacer.

A lateral width of the second spacer may be greater than a lateral width of the first spacer and smaller than twice the lateral width of the first spacer. The proximal spacer portion may adjoin the distal spacer portion at the center region of the second spacer.

A lateral width of the second spacer may be greater than twice a lateral width of the first spacer. The proximal spacer portion may be laterally separated from the distal spacer portion.

The LDMOS device may include an oxide spacer part that overlies at least the center region of the second spacer.

The oxide spacer part may at least partially fill a space located between the proximal spacer portion and the distal spacer portion.

The LDMOS device may include a layer of dielectric completely covering the gate, the first spacer and the second spacer.

According to a further aspect of the present disclosure, there is provided a method of making a semiconductor device, the method comprising:
providing a semiconductor die having a major surface;
depositing a gate dielectric and a gate electrode layer on the major surface;
masking the gate electrode layer;
etching the gate electrode layer through the mask to form a gate and a sacrificial gate portion laterally separated from the gate;
forming a first spacer located adjacent to a first sidewall of the gate on a first side of the gate;
forming a second spacer located adjacent to a second sidewall of the gate on a second side of the gate opposite said first side of the gate, wherein the second spacer adjoins both the gate and the sacrificial gate portion;
removing the sacrificial gate portion;
forming a source region located in the semiconductor die on said first side of the gate; and
forming a drain drift region located in the semiconductor die on said second side of the gate, wherein the second spacer is located between the gate and the drain drift region when viewed from above said major surface of the semiconductor die.

The second spacer may include a proximal spacer portion and a distal spacer portion. The proximal spacer portion may be located between the gate and the distal spacer portion. The proximal spacer portion and the distal spacer portion may define a recess located in a center region of the second spacer.

The sacrificial gate portion may be laterally separated from the gate by a distance that is greater than a lateral width of the first spacer and smaller than twice the lateral width of the first spacer. The proximal spacer portion may adjoin the distal spacer portion at the center region of the second spacer. The sacrificial gate portion may be laterally separated from the gate by a distance that is greater than twice a lateral width of the first spacer. The proximal spacer portion may be laterally separated from the distal spacer portion.

### BRIEF DESCRIPTION OF THE DRAWINGS

Embodiments of this disclosure will be described hereinafter, by way of example only, with reference to the accompanying drawings in which like reference signs relate to like elements and in which:
Figure 1 shows an example of an LDMOS device;
Figure 2 shows an LDMOS device according to an embodiment of this disclosure;
Figure 3 shows an LDMOS device according to another embodiment of this disclosure;
Figures 4A-4F show a method of making an LDMOS device of the kind shown in Figure 2, according to an embodiment of this disclosure; and
Figures 5A-5J show a method of making an LDMOS device of the kind shown in Figure 3, according to an embodiment of this disclosure.

### DETAILED DESCRIPTION

Embodiments of this disclosure are described in the following with reference to the accompanying drawings.

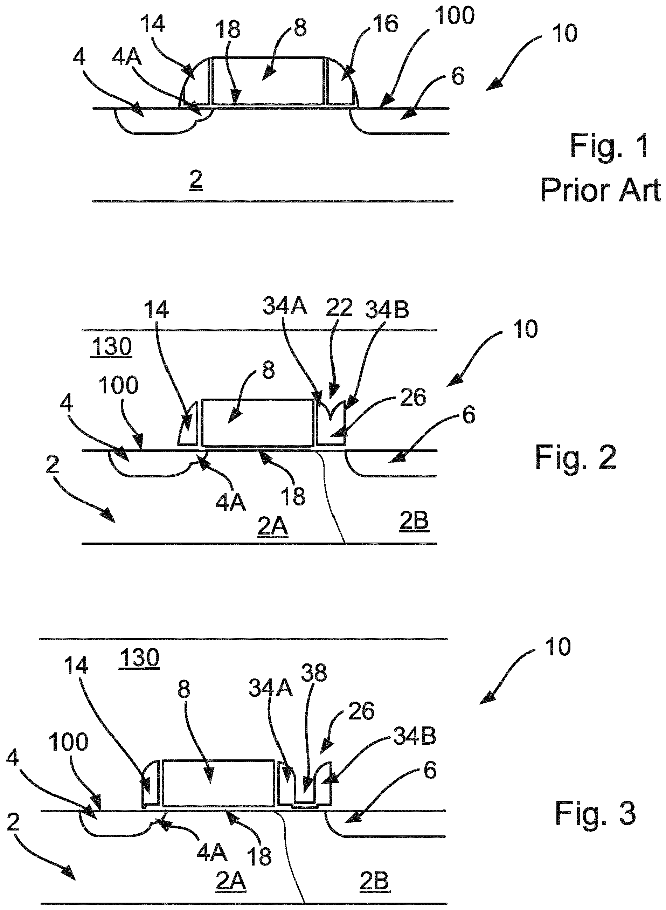

Figure 1 shows an example of a laterally-diffused metal-oxide semiconductor, "LDMOS", device 10. The semiconductor device 10 includes a semiconductor (e.g., silicon) substrate 2. The substrate 2 has a major surface 100. The semiconductor device 10 also includes a gate 8 located on the major surface 100. A gate dielectric 18 (e.g., an oxide) is located in between the gate 8 and the major surface 100. The gate is provided with spacers 14, 16. The gate dielectric may also extend between the spacers and the gate, and between the spacers 14, 16 and the major surface 100.

The semiconductor device 10 further includes a source region 4, which is located on a first side (the left-hand side of the gate 8 as viewed in the example of Figure 1) of the gate 8. The source region 4 may include an extension region 4A located substantially beneath the spacer 14 on the first side of the gate 8.

The semiconductor device 10 further includes a drain including a drain drift region 6, which is located on a second side of the gate 8 opposite the first side (the right-hand side of the gate 8 as viewed in the example of Figure 1).

The breakdown voltage of a self-aligned LDMOS device 10 of the kind shown in Figure 1 may generally be limited by the gate oxide 18 thickness of the semiconductor device 10.

Figure 2 shows a laterally-diffused metal-oxide, "LDMOS", device 10 according to an embodiment of this disclosure.

The semiconductor device 10 includes a semiconductor (e.g., silicon) substrate 2. The substrate 2 has a major surface 100. The substrate 2 has a first doped region 2A and a second doped region 2B. The first doped region 2A corresponds substantially to a gate channel region of the device 10, while the second doped region contains a drain drift region 6 of the device 10. The first doped region 2A may be doped to have a first conductivity type and the second doped region 2B may be doped to have a second conductivity type. In this embodiment, the first conductivity type is p-type, and the second conductivity type is n-type.

The semiconductor device 10 also includes a gate 8 located on the major surface 100. In particular, the gate 8 may be located above the first doped region 2A. A gate dielectric 18 (e.g., an oxide) is located in between the gate 8 and the major surface 100. The gate 8 is provided with spacers 14, 26. The first spacer 14 is located adjacent to a first sidewall of the gate 8 on a first side of the gate 8 (the left-hand side of the gate 8 as viewed in the example of Figure 2). The second spacer 26 is located adjacent to a second sidewall of the gate 8 on a second side of the gate 8 (the right-hand side of the gate 8 as viewed in the example of Figure 2) opposite the first side of the gate 8. Dielectric may extend between the spacers 14, 26 and the gate 8, and between the spacers 14, 26 and the major surface 100.

The semiconductor device 10 further includes a source region 4, which is located on the first side of the gate 8. The source region 4 may include an extension region 4A located substantially beneath the spacer 14 on the first side of the gate 8. The source region 4 and the extension region 4A may be doped regions having the second conductivity type (n-type, in this embodiment).

The semiconductor device 10 further includes a drain including a drain drift region 6, which is located on the second side of the gate 8. The drain drift region 6 may be a doped region having the second conductivity type (n-type, in this embodiment). The source region 4, the extension region 4A and the drain drift region 6 may be more highly doped than the second doped region 2B.

The gate 8 may be covered with a dielectric region 130. The dielectric region 130 may include conductive interconnects for making electrical connections to the source region 4, the drain drift region 6 and the gate 8. The dielectric region 130 may also cover the spacers 14, 26, as well as at least part of the source region 4 and the drain drift region 6.

The second spacer 26 is located between the gate 8 and the drain drift 6 region when viewed from above the major surface 100.

The second spacer 26 has a proximal spacer portion 34A and a distal spacer portion 34B. The proximal spacer portion 34A is proximal to the gate 8 and is located between the gate 8 and the distal spacer portion 34B. The distal spacer portion 34B may be located between the proximal spacer portion 34A and the drain drift region 6 when viewed from above the major surface 100. As shown in Figure 2, the proximal spacer portion 34A and the distal spacer portion 34B define a recess 22. The recess 22 is located in a center region of the second spacer 26. The recess 22 may be filled with dielectric (e.g., oxide), for instance the dielectric of the dielectric region 130.

In the present embodiment, a lateral width (measured along the dimension of the channel region of the device 10) of the second spacer 26 is greater than a lateral width of the first spacer 14 and smaller than twice the lateral width of the first spacer 14. As will be described below, proximal spacer portion 34A and the distal spacer portion 34B of the second spacer 26 may each be formed using a similar or the same process as the process for forming the first spacer 14. In the present embodiment, the proximal spacer portion 34A adjoins the distal spacer portion 34B at the center region of the second spacer 26. The recess 22 may thus be formed at the point at which the proximal spacer portion 34A meets the distal spacer portion 34B.

Figure 3 shows a laterally-diffused metal-oxide, "LDMOS", device 10 according to another embodiment of this disclosure. The device 10 in this embodiment is similar in some respects to the device shown in Figure 2, and only the differences will be described here in detail.

The gate 8 in this embodiment is again provided with spacers 14, 26. The first spacer 14 is located adjacent to a first sidewall of the gate 8 on a first side of the gate 8 (the left-hand side of the gate 8 as viewed in the example of Figure 3). As in the embodiment of Figure 2, the second spacer 26 is located adjacent to a second sidewall of the gate 8 on a second side of the gate 8 (the right-hand side of the gate 8 as viewed in the example of Figure 3) opposite the first side of the gate 8. Again, dielectric may extend between the spacers 14, 26 and the gate 8, and between the spacers 14, 26 and the major surface 100.

The second spacer 26 is again located between the gate 8 and the drain drift 6 region when viewed from above the major surface 100. The second spacer 26 in this embodiment again has a proximal spacer portion 34A and a distal spacer portion 34B. The proximal spacer portion 34A is proximal to the gate 8 and is located between the gate 8 and the distal spacer portion 34B. The distal spacer portion 34B may be located between the proximal spacer portion 34A and the drain drift region 6 when viewed from above the major surface 100.

As shown in Figure 3, the proximal spacer portion 34A and the distal spacer portion 34B define a recess. The recess is located in a center region of the second spacer 26. The recess may be at least partially filled with dielectric (e.g., oxide), for instance the dielectric of the dielectric region 130, thereby to form an oxide spacer part that overlies at least the center region of the second spacer 26. Note that in this embodiment, the recess forms a space or gap 38, which laterally separates the proximal spacer portion 34A from the distal spacer portion 34. The space 38 may be chosen to have a lateral width according to the desired overall lateral width of the second spacer 26. Note that in this embodiment, the lateral width of the second spacer 26 is greater than twice a lateral width of the first spacer 14.

As is known in the art, the vertical height (e.g., measured from the major surface 100 of the substrate 2 in Figure 1) of spacers provided on the sidewalls of gates may taper (reduce) with increasing distance from the gate. The first spacer 14 of the embodiments shown in Figures 2 and 3 may taper conventionally in this way. However, the second spacer 26 in the embodiments of Figures 2 and 3 does not taper in this way, owing to the presence of the recess 22.

To form the recess 22, the proximal spacer portion 34A may have a vertical height (e.g., measured from the major surface 100 of the substrate 2 in Figures 2 and 3) which tapers (reduces) with increasing distance from the gate 8, while the distal spacer portion 34B may have a vertical height (e.g., measured from the major surface 100 of the substrate 2 in Figures 2 and 3) which tapers (reduces) with decreasing distance from the gate 8. Thus, the opposite directions of the tapering of the proximal spacer portion 34A and the distal spacer portion 34B may form the recess 22 of the second spacer 26. In the embodiment of Figure 2, the vertical heights of the proximal spacer portion 34A and the distal spacer portion 34B do not taper to zero, since the proximal spacer portion 34A adjoins the distal spacer portion 34B. However, in the embodiment of Figure 3, the vertical heights of the proximal spacer portion 34A and the distal spacer portion 34B may taper to zero or nearly zero, thereby to form the space or gap 38, which laterally separates the proximal spacer portion 34A from the distal spacer portion 34.

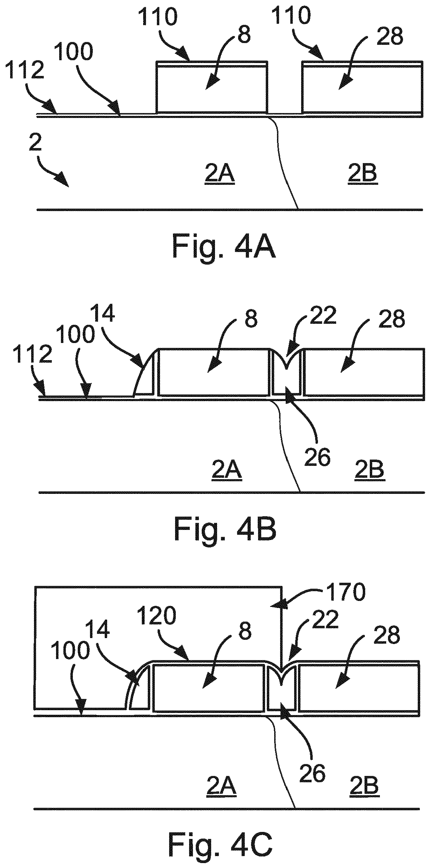

Figures 4A-4F show a method of making an LDMOS device 10 of the kind shown in Figure 2, according to an embodiment of this disclosure.

In a first stage, shown in Figure 4A, a semiconductor (e.g., silicon) substrate 2 is provided. The substrate 2 has a major surface 100. The substrate 2 has a first doped region 2A and a second doped region 2B, which may be formed using masking and ion implantation steps. The first doped region 2A corresponds substantially to a gate channel region of the device 10, while the second doped region contains a drain drift region 6 of the device 10. The first doped region 2A may be doped to have a first conductivity type and the second doped region 2B may be doped to have a second conductivity type. In this embodiment, the first conductivity type is p-type, and the second conductivity type is n-type.

In the first stage, the gate 8 of the device 10 may be formed. This may involve depositing a gate dielectric 112 on the major surface 100 of the substrate 2 and then depositing a gate (electrode) material, such as polysilicon, onto the gate dielectric 112. As can be seen in Figure 4A, the formation of the gate may also involve forming a sacrificial part 28, e.g., from the same material as the gate 8. The gate 8 and sacrificial part 28 may be formed using a number of mask and etch steps. For instance, following the deposition of the gate material on the major surface 100, a mask 110 may be formed on the gate material. The mask 110 may have openings through which the gate material may be etched away, thereby arriving at the arrangement shown in Figure 4A. The mask may be patterned such that, after etching the gate material, the gate 8 is located above the first doped region 2A and the sacrificial part 28 is located on the second side of the gate 8, above the second doped region 2B and laterally separated from the gate by a space. This space will subsequently be used to define the second spacer 26. The lateral width of the space between the gate 28 and the sacrificial part 28 may thus be chosen according to the desired lateral width of the second spacer 26. In the present embodiment, the lateral width of the space between the gate 28 and the sacrificial part 28 is chosen to be greater than a lateral width of the first spacer 14 and smaller than twice the lateral width of the first spacer 14, to be formed subsequently. After the etching of the gate material, the mask 110 may be removed.

In a next stage, shown in Figure 4B, the first spacer 14 and the second spacer 26 are formed. Prior to the deposition of the spacer material, dielectric may be grown on the sidewalls of the gate 8 and the sacrificial part 28. The spacer material may then be deposited over the gate and the sacrificial part 28. Note that the spacer material substantially fills the space between the gate 8 and the sacrificial part 28. The spacer material may then be etched back. In one embodiment, the etching of the spacer material may be performed with an anisotropic etch. In terms of the first spacer 14, the etching back may conventionally form a tapered spacer. However, for the second spacer 26, the etching back of the spacer material leads to the formation of the proximal spacer portion 34A which tapers from the edge of the gate 8 and the formation of the distal spacer portion 34B, which tapers from the edge of the sacrificial part 29. This leads to the formation of the recess 22.

In a next stage, shown in Figure 4C, a masking material 170 such as photoresist is deposited and patterned such that an edge of the masking material 170 falls between the gate 8 and the sacrificial part 28. Prior to the deposition of the masking material 170, a dielectric layer 120 may be formed over the gate 8, the spacers 14, 26 and/or the sacrificial part 28.

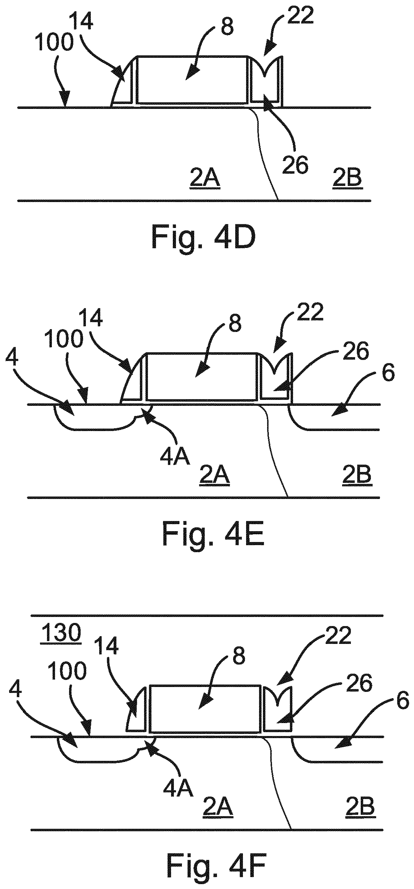

In a next stage, shown in Figure 4D, the sacrificial part 28 may be removed by etching. Note that the masking material 170 may protect the gate 8 form etching during this stage. The masing material may then be removed. Further etching may be used to remove the dielectric 120 and the parts of the gate dielectric which are not located beneath the gate 8 and spacers 14, 26.

In a next stage, shown in Figure 4E, the source region 4, extension region 4A and drain drift region 6 may be formed e.g., using ion implantation followed by an anneal to activate the dopants. The spacer 14 defines the edge of the source region 4 closest to the gate 8 in a self-aligned manner. Similarly, the spacer 26 defines the edge of the drain drift region 6 closest to the gate 8 in a self-aligned manner. Note that, because the lateral width of the second spacer 26 is greater than the lateral width of a conventional spacer (e.g., spacer 14) the edge of the drain drift region 6 may be located further away from the gate 8. This may allow the device 10 to have a relatively high breakdown voltage.

In a next stage, shown in Figure 4F, the dielectric region 130 may be deposited and patterned. The dielectric region 130 may include conductive interconnects for making electrical connections to the source region 4, the drain drift region 6 and the gate 8. Note that the dielectric region 130 may substantially fill the recess 22.

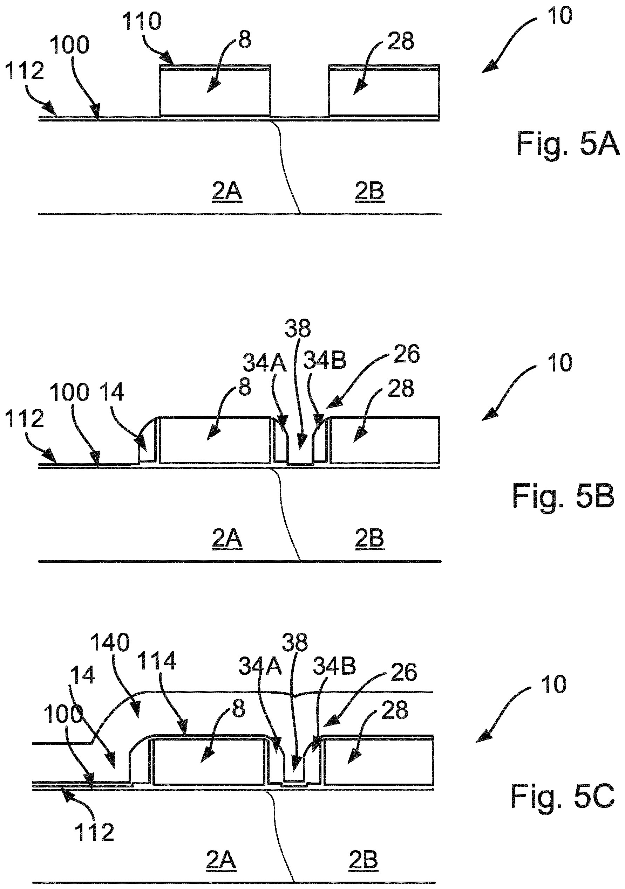

Figures 5A-5J show a method of making an LDMOS device 10 of the kind shown in Figure 3, according to an embodiment of this disclosure.

This stage of the method may be substantially as described above in relation to Figure 4A. However, unlike in Figure 4A, in the present embodiment, the lateral width of the space between the gate 28 and the sacrificial part 28 is chosen to be greater than twice a lateral width of the first spacer 14, to be formed subsequently.

In a next stage, shown in Figure 5B, the first spacer 14 and the second spacer 26 are formed. Prior to the deposition of the spacer material, dielectric may be grown on the sidewalls of the gate 8 and the sacrificial part 28. The spacer material may then be deposited over the gate and the sacrificial part 28. Note that the spacer material substantially fills the space between the gate 8 and the sacrificial part 28. The gate material may then be etched back. In terms of the first spacer 14, the etching back may conventionally form a tapered spacer.

However, for the second spacer 26, the etching back of the spacer material leads to the formation of the proximal spacer portion 34A which tapers from the edge of the gate 8 and the formation of the distal spacer portion 34B, which tapers from the edge of the sacrificial part 29. Moreover, because the lateral width of the space between the gate 28 and the sacrificial part 28 is chosen to be greater than twice a lateral width of the first spacer 14, the vertical height of both the proximal spacer portion 34A and the distal spacer portion 34B may reduce to zero (or near zero) such that the recess 22 between the proximal spacer portion 34A and the distal spacer portion 34B takes the form of the space or gap 38 described above in relation to Figure 3. The space 38 may be chosen to have a lateral width according to the desired overall lateral width of the second spacer 26, and this may be determined by the lateral spacing between the gate 8 and the sacrificial part 28.

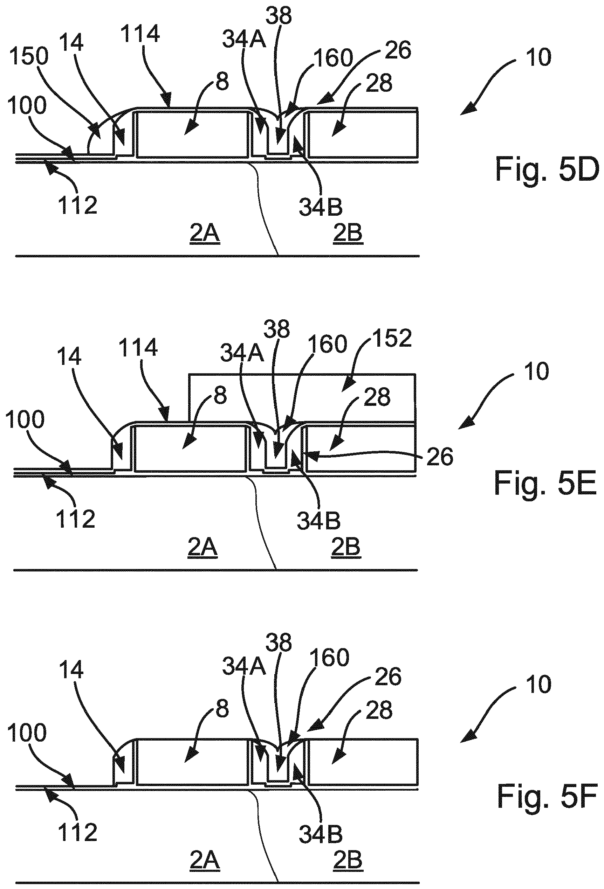

In a next stage, shown in Figure 5C, dielectric 140 (e.g., Tetraethyl orthosilicate (TEOS)), may be deposited over the arrangement shown in Figure 5B. Prior to the deposition of the dielectric 140, a dielectric layer 114 may be formed over the gate 8, the spacers 14, 26 and/or the sacrificial part 28. This may protect, for example, the gate 8 during the etching described below in relation to Figure 5E.

In a next stage, shown in Figure 5D, the dielectric 140 may be etched back to form further spacer parts 150, 160.

The further spacer part 150 may cover the first spacer 14 and may taper downwardly from the edge of the gate 8, although at a slower tapering rate than the first spacer 14, such the further spacer part 150 extends further from the gate 8 than the first spacer 14.

The further spacer part 160 may substantially fill the space or gap 38 and may cover the proximal spacer portion 34A and the distal spacer portion 34B. As with the further spacer part 150, the further spacer part 160 may taper away from the gate 8 and the sacrificial part 28 at a slower rate than the proximal spacer portion 34A and the distal spacer portion 34B. Note that a recess may be located in the further spacer part 160, similar to the recess 22 in the second spacer 22.

In a next stage, shown in Figure 5E, a masking material 152 such as photoresist may be deposited and patterned such that an edge of the masking material 152 falls above the gate 8. The further spacer part 150 may then be removed by etching. After the further spacer part 150 has been etched away, the masking material 152 may be removed (the dielectric layer 114 may also be removed), leading to the arrangement shown in Figure 5F.

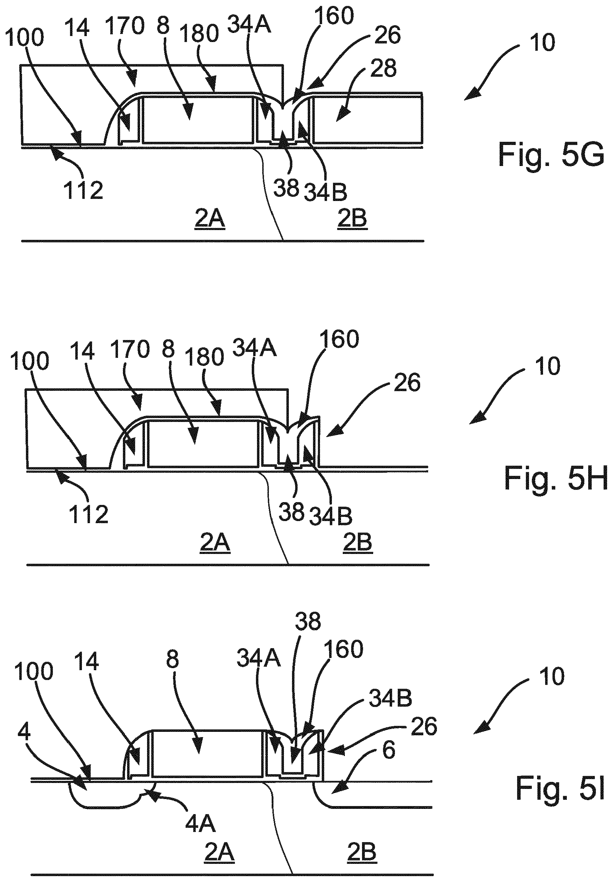

In a next stage, shown in Figure 5G, a masking material 170 such as photoresist is deposited and patterned such that an edge of the masking material 170 falls between the gate 8 and the sacrificial part 28. Prior to the deposition of the masking material 170, a dielectric layer 180 may be formed over the gate 8, the spacers 14, 26 and/or the sacrificial part 28.

In a next stage, shown in Figure 5H, the sacrificial part 28 may be removed by etching. Note that the masking material 170 may protect the gate 8 form etching during this stage. The masking material 170 may then be removed. Further etching may be used to remove the dielectric 180 and the parts of the gate dielectric 112 which are not located beneath the gate 8 and spacers 14, 26.

In a next stage, shown in Figure 5I, the source region 4, extension region 4A and drain drift region 6 may be formed e.g., using ion implantation followed by an anneal to activate the dopants. The spacer 14 defines the edge of the source region 4 closest to the gate 8 in a self-aligned manner. Similarly, the spacer 26 defines the edge of the drain drift region 6 closest to the gate 8 in a self-aligned manner. Note that, because the lateral width of the second spacer 26 may be chosen as described above, the edge of the drain drift region 6 may be located further away from the gate 8, when compared to a conventional spacer. This may allow the device 10 to have a relatively high breakdown voltage. In contrast to the embodiment of Figures 2 and 4, the present embodiment may allow for a greater spacing between the drain drift region 6 and the gate 8.

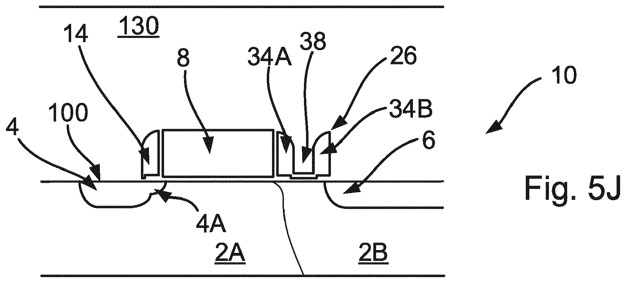

In a next stage, shown in Figure 5J, the dielectric region 130 may be deposited and patterned. The dielectric region 130 may include conductive interconnects for making electrical connections to the source region 4, the drain drift region 6 and the gate 8. Note that the dielectric region 130 in this embodiment may sit above the further spacer part 160. In this way, the material filling the space 38 may be chosen to be different to the material of the dielectric region 130.

Accordingly, there has been described a laterally-diffused metal-oxide semiconductor, "LDMOS", device and a method of making the same. The device includes a gate located on a major surface of a semiconductor die, a source region located in the die on a first side of the gate, a drain drift region located in the die on a second side of the gate opposite the first side, a first spacer located adjacent to a first sidewall of the gate on the first side of the gate, and a second spacer located adjacent to a second sidewall of the gate on the second side of the gate. The second spacer is located between the gate and the drain drift region. The second spacer comprises a proximal spacer portion and a distal spacer portion. The proximal spacer portion is located between the gate and the distal spacer portion. The proximal spacer portion and the distal spacer portion define a recess.

Although particular embodiments of this disclosure have been described, it will be appreciated that many modifications/additions and/or substitutions may be made within the scope of the claims.

## Claims

1. A method of making a laterally-diffused metal-oxide semiconductor, "LDMOS", device, the method comprising:
providing a semiconductor die having a major surface;
forming a gate on the maj or surface of the semiconductor die;
forming a first spacer located adjacent to a first sidewall of the gate on a first side of the gate;
forming a second spacer located adjacent to a second sidewall of the gate on a second side of the gate opposite said first side of the gate;
forming a source region located in the semiconductor die on said first side of the gate; and
forming a drain drift region located in the semiconductor die on said second side of the gate,
wherein the second spacer is located between the gate and the drain drift region when viewed from above said major surface of the semiconductor die, wherein the second spacer comprises a proximal spacer portion and a distal spacer portion, wherein the proximal spacer portion is located between the gate and the distal spacer portion, and wherein the proximal spacer portion and the distal spacer portion define a recess located in a center region of the second spacer.

2. The method of claim 1, wherein:
forming the gate includes forming a sacrificial gate portion laterally separated from the gate on the second side of the gate; and
forming the second spacer comprises forming the proximal spacer portion adjacent to the second sidewall of the gate and forming the distal spacer portion adjacent to a sidewall of the sacrificial gate portion facing the second sidewall of the gate.

3. The method of claim 2, further comprising removing the sacrificial gate portion after forming the second spacer.

4. The method of claim 3, comprising:
depositing a mask on the gate, the first spacer and at least part of the second spacer; and
removing the sacrificial gate portion by etching.

5. The method of claim 3 or 4, comprising forming the drain drift region after removal of the sacrificial gate portion.

6. The method of any one of claims 2 to 5, wherein the sacrificial gate portion is laterally separated from the gate by a distance that is greater than a lateral width of the first spacer and smaller than twice the lateral width of the first spacer, and wherein the proximal spacer portion adjoins the distal spacer portion at the center region of the second spacer.

7. The method of any one of claims 2 to 5, wherein the sacrificial gate portion is laterally separated from the gate by a distance that is greater than twice a lateral width of the first spacer, and wherein the proximal spacer portion is laterally separated from the distal spacer portion.

8. The method of claim 7, further comprising:
depositing an oxide layer over the gate, the sacrificial gate portion, the first spacer and the second spacer; and
etching the oxide layer back, to form:
a first oxide spacer part that overlies at least part of the first spacer; and
a second oxide spacer part that overlies at least the center region of the second spacer.

9. The method of claim 8, wherein the second oxide spacer part at least partially fills a space located between the proximal spacer portion and the distal spacer portion.

10. The method of claim 9, further comprising:
masking the second spacer; and
removing the first oxide spacer part from the first spacer.

11. The method of any preceding claim, further comprising depositing a layer of dielectric to completely cover the gate, the first spacer and the second spacer.

12. A laterally-diffused metal-oxide semiconductor, "LDMOS", device comprising:
a gate located on a major surface of a semiconductor die;
a source region located in the semiconductor die on a first side of the gate
a drain drift region located in the semiconductor die on a second side of the gate opposite said first side of the gate;
a first spacer located adjacent to a first sidewall of the gate on said first side of the gate; and
a second spacer located adjacent to a second sidewall of the gate on said second side of the gate,
wherein the second spacer is located between the gate and the drain drift region when viewed from above said major surface of the semiconductor die, wherein the second spacer comprises a proximal spacer portion and a distal spacer portion, wherein the proximal spacer portion is located between the gate and the distal spacer portion, and wherein the proximal spacer portion and the distal spacer portion define a recess located in a center region of the second spacer.

13. The LDMOS device of claim 12, wherein a lateral width of the second spacer is greater than a lateral width of the first spacer and smaller than twice the lateral width of the first spacer, and wherein the proximal spacer portion adjoins the distal spacer portion at the center region of the second spacer.

14. The LDMOS device of claim 12, wherein a lateral width of the second spacer is greater than twice a lateral width of the first spacer, and wherein the proximal spacer portion is laterally separated from the distal spacer portion.

15. The LDMOS device of claim 14, comprising an oxide spacer part that overlies at least the center region of the second spacer.
